# FASCICULE DE BREVET EUROPEEN

(11) **EP 0 461 035 B1**
(45) Date de publication et mention de la délivrance du brevet: **21.09.1994**
(21) Numéro de dépôt: 91401474.1
(22) Date de dépôt: 06.06.1991
(51) Int. Cl.: H01J 37/34

(54) **Cathode rotative**
Drehkathode
Rotating cathode

(30) Priorité: 08.06.1990 BE 9000577
(43) Date de publication de la demande: 11.12.1991
(73) Titulaire: SAINT-GOBAIN VITRAGE INTERNATIONAL, 92400 Courbevoie (FR); GLACERIES SAINT ROCH S.A., B-5060 Sambreville (BE)
(72) Inventeur: Devigne, Roland, B-5060 Falisolle (BE); Beaufays, Jean-Pierre, B-5190 Jemeppe s//Sambre (BE)
(74) Mandataire: Muller, René

(56) Documents cités:
- EP-A- 0 084 971
- GB-A- 2 096 177
- US-A- 4 132 612
- JOURNAL OF VACUUM SCIENCE AND TECHNOLOGY: PART A. vol. 4, no. 3, Mai 1986, NEW YORK US pages 388 - 392; M. WRIGHT ET AL.: 'Design advances and applications of the rotatable cylindrical magnetron '

## Description

L'invention concerne une cathode de pulvérisation à cible rotative selon la première partie des revendications 1 et 14.

Une telle cathode est connue du "Journal of Vacuum Science and Technologie, Part A, vol 4, no. 3, Mai 1986, New York US, pages 388-392; M. Wright et Al.

La pulvérisation cathodique est une technique désormais éprouvée pour l'application en couches minces et uniformes d'une matière de revêtement sur des substrats variés.

La technique de pulvérisation cathodique, qui est notamment décrite dans US-A-146-025, est pratiquée au moyen d'une cathode connectée à une alimentation électrique et placée dans une enceinte sous vide dans laquelle sont injectées des traces de gaz (par exemple, l'argon). Une cible, réalisée en la matière destinée à être pulvérisée, est montée sur la cathode. Cette cible est bombardée par les ions énergétiques produits par la rencontre de molécules de gaz dispersés dans l'enceinte et d'électrons accélérés par le champ électrique et confinés magnétiquement près de la cible.

Les ions gazeux à énergie cinétique élevée sont précipités sur la cible avec une énergie suffisante pour en arracher des particules. Ces dernières se condensent sur le substrat à recouvrir, qui est disposé sur leur trajet, et il se dépose ainsi sur celui-ci une fine couche de matière.

Cette couche peut consister en un métal ou en un alliage (on dit alors que l'on travaille en mode de pulvérisation métallique).

On peut également déposer ainsi une substance formée par réaction chimique entre la matière de la cible et un gaz réactif introduit en faibles quantités dans la chambre de pulvérisation (on parle alors d'une pulvérisation en mode réactif).

La cathode rotative suivant l'invention peut être utilisée avantageusement avec les deux modes de pulvérisation, aussi bien métallique que réactif, mais elle est particulièrement bien adaptée à un usage en mode réactif.

Le rendement des appareils de pulvérisation sous vide était, à l'origine très faible, du fait de la faible probabilité de rencontre entre les ions et les électrons dans l'enceinte. En confinant les électrons au voisinage de la cible, on augmente de façon substantielle le taux d'ionisation et l'on peut opérer à plus faible pression, en augmentant ainsi la pureté des dépôts.

Le brevet US-A-4 166 018 décrit une cathode à cible plane, derrière laquelle des aimants sont disposés, de façon à réaliser une zone de confinement fermée sur elle-même, en forme de piste ovale, dans laquelle les électrons sont piégés, d'où un accroissement important du taux de collision avec les atomes de gaz, donc des impacts d'ions sur la cathode, et donc du taux de pulvérisation.

Dans une telle cathode, la cible subit une érosion localisée en forme de sillon, qui suit le tracé magnétique. Cela entraîne la nécessité de remplacements fréquents de la cible, et un faible taux d'utilisation de la matière de la cible.

Différents procédés ont été utilisés pour mieux répartir l'érosion sur l'étendue de la cible. Ainsi, dans le brevet US-4 525 264, on superpose un champ magnétique variable à celui du circuit de confinement magnétique placé derrière la cible.

Le brevet US-A-4 422 916 décrit une cathode dotée d'une cible montée sur une structure en forme de cylindre rotatif, des moyens magnétiques de confinement étant disposés le long d'une génératrice à l'intérieur de la structure cylindrique. L'usure de la cible est uniformisée par déplacement angulaire de la zone d'érosion. Comme les moyens de confinement sont disposés à l'intérieur de la structure cylindrique, cette dernière doit nécessairement avoir des dimensions importantes. Cette structure étant, en outre, remplie d'un fluide de refroidissement subit, de par son poids, de fortes contraintes mécaniques. En conséquence, le taux d'utilisation de la cible ne peut généralement pas dépasser 40%.

Par ailleurs, les aimants et les pièces du circuit magnétique, confinés dans le volume interne de la structure cylindrique, font obstacle à la circulation du fluide de refroidissement et cela principalement dans la zone où a lieu l'échauffement de la cible. Il en résulte que le refroidissement n'est pas très satisfaisant, précisément à l'endroit où il devrait être très efficace. De surcroît, comme les aimants et les pièces magnétiques baignent constamment dans ce fluide de refroidissement, qui est habituellement de l'eau, il se pose nécessairement des problèmes de corrosion.

La présente invention a pour but de procurer une cathode dans laquelle le taux d'utilisation de la cible soit élevé.

Un autre but de l'invention est que la cible subisse une érosion plus uniforme sur toute sa surface.

Un autre but de l'invention est d'obtenir une cathode dans laquelle la cible soit d'un coût de fabrication relativement peu élevé et soit, de surcroît, facile à remplacer.

L'invention a également pour but d'obtenir une cathode dans laquelle la dissipation de l'énergie thermique engendrée par la pulvérisation soit améliorée par rapport aux systèmes connus.

Un autre but est que la cathode puisse travailler à plus basse température en limitant l'échauffement de la cible.

L'objet de l'invention est une cathode de pulvérisation sous vide comportant une structure creuse, en substance en forme de corps de révolution, pouvant tourner autour de son axe. Cette structure creuse comprend une paroi latérale qui s'étend périphériquement suivant l'axe, et deux faces d'about en substance perpendiculaires à l'axe, ladite structure creuse étant constituée, au moins à l'extérieur de sa paroi latérale, de matière à pulvériser. La cathode comporte également un circuit de confinement magnétique fixe disposé à proximité d'une cible; ce circuit comprend des pôles, des pièces en métal magnétiquement perméable et des moyens magnétiques aptes à engendrer un flux magnétique dans ce circuit, des moyens de raccordement à un circuit de refroidissement apte à faire circuler un fluide de refroidissement dans la structure creuse, des moyens de raccordement à un circuit d'alimentation électrique et des moyens d'entraînement aptes à entraîner la structure creuse en rotation autour de son axe; dans cette cathode, le circuit magnétique s'étend périphériquement par rapport à la structure creuse, les moyens magnétiques étant disposés extérieurement à celle-ci; les pôles du circuit magnétique sont disposés suivant deux lignes génératrices de cette structure creuse, l'arc de la paroi latérale de la structure creuse compris entre ces deux lignes génératrices formant la cible de la cathode.

Suivant une forme d'exécution avantageuse, la structure creuse, en substance en forme de corps de révolution, est un cylindre.

Suivant une forme d'exécution avantageuse, la surface latérale extérieure de la structure creuse rotative est constituée par une couche massive de matière à pulvériser.

Suivant une autre forme d'exécution, la structure creuse rotative comporte un support de forme appropriée recouvert de matière à pulvériser.

De façon avantageuse, les moyens de raccordement à un circuit de refroidissement sont situés sur la même face d'about de la structure creuse. De façon préférée, les moyens de raccordement au circuit de refroidissement sont coaxiaux.

Dans une version avantageuse de la cathode, les pièces du circuit magnétique comportent également des moyens de raccordement à un circuit de refroidissement distinct de celui de la structure creuse.

Suivant une forme d'exécution particulière, les pôles du circuit magnétique supportent une pièce polaire dont la section a la forme d'un coin, l'arête de ladite pièce polaire étant dirigée sensiblement vers le bord de la cible, la face tournée vers l'entrefer, en substance plane, formant avec la surface de la cible, un angle de 90°, de façon telle que les lignes de force du champ magnétique s'étendent entre lesdites pièces polaires suivant une courbure proche de celle de la cible, à proximité immédiate de celle-ci.

Suivant un mode de réalisation avantageux, la cathode comporte deux structures creuses disposées côte à côte, leur axe étant parallèle à l'axe de la cathode, leurs circuits magnétiques respectifs comportant au moins une partie commune.

Dans une forme de ce mode de réalisation, les pièces polaires des circuits magnétiques de chaque structure creuse sont toutes disposées d'un même côté de la cathode, de sorte que les cibles correspondantes sont aptes à pulvériser dans une même direction angulaire; une branche polaire s'étendant entre les deux structure creuses forme une partie commune aux deux circuits magnétiques, une pièce polaire commune étant portée par cette branche commune.

Suivant une autre forme de ce mode de réalisation, les pièces polaires des deux cathodes sont disposées sur deux faces opposées de la cathode; les cibles correspondant à chaque structure creuse sont situées de façon diamétralement opposée l'une par rapport à l'autre, aptes à pulvériser dans deux plans parallèles; les circuits magnétiques s'étendent périphériquement à chacune des cibles et comportent une partie centrale commune s'étendant entre les cibles.

Suivant encore une autre forme de ce mode de réalisation, la cathode comporte un nombre n de structures creuses disposées côte à côte, leurs circuits magnétiques respectifs comportant au moins une partie commune.

Suivant une forme d'exécution avantageuse, la structure creuse rotative est entourée, à l'exclusion de l'arc formant la cible, d'une gaine parcourue par un fluide cryogénique, apte à provoquer un échange thermique radiatif avec la surface de la cible.

Suivant une forme de réalisation différente de la cathode selon l'invention, celle-ci comporte une structure creuse, en substance en forme de corps de révolution, pouvant tourner autour de son axe. Cette structure comprend une paroi latérale qui s'étend périphériquement suivant cet axe, et deux faces d'about en substance perpendiculaires à cet axe; cette structure creuse forme un volume fermé constitué, au moins à l'extérieur de sa paroi latérale, de matière à pulvériser. La cathode comporte également un circuit de confinement magnétique fixe disposé à proximité d'une "cible" , ce circuit comportant des pôles, des pièces en métal magnétiquement perméable et des moyens magnétiques aptes à engendrer un flux magnétique dans ce circuit, des moyens de raccordement à un circuit de refroidissement apte à faire circuler un fluide de refroidissement dans la structure creuse et des moyens d'entraînement aptes à entraîner la structure creuse en rotation autour de son axe.

Dans ladite cathode, le circuit magnétique forme deux boucles se refermant de façon symétrique, les moyens magnétiques, les pôles et la majeure partie du circuit magnétique étant disposés extérieurement à la structure creuse de part et d'autre de celle-ci, les pôles magnétiques de chaque boucle étant disposés suivant deux lignes génératrices de cette structure, déterminant des segments angulaires diamétralement opposés sur la paroi latérale de cette structure, ces segments angulaires constituant deux cibles aptes à pulvériser de la matière dans deux directions opposées;
les parties du circuit magnétique disposées de part et d'autre à l'extérieur de la structure creuse rotative sont reliées magnétiquement par un noyau de pontage en fer doux placé de façon non rotative à l'intérieur de cette structure creuse rotative, suivant le plan transversal comprenant l'axe de la cathode, chaque extrémité de ce moyen de pontage venant en regard, par-delà la paroi latérale de la structure creuse, d'une extension des parties du circuit magnétique disposées à l'extérieur de la structure.

Outre le fait d'avoir atteint les buts énoncés ci-dessus, la cathode, suivant l'invention, présente notamment les avantages suivants :
- elle permet de pulvériser des métaux ou alliages à bas point de fusion sans risque de fusion de la cible;
- la configuration particulière de la cible permet d'utiliser des méthodes de fabrication nouvelles et avantageuses (charge par sputtering, coulage, électrolyse, ...);
- les pièces polaires, essentiellement composées de fer, se recouvrent ou peuvent être préalablement couvertes d'une pellicule de métal pulvérisé par la cible et n'interviennent pratiquement pas dans la composition de la couche pulvérisée sur le substrat;
- la forme des pièces polaires peut facilement être modifiée en fonction des critères de confinement désirés;
- il est possible d'accoler les cathodes suivant l'invention et d'obtenir ainsi un rendement global de pulvérisation accrue par unité de volume ou de longueur de l'installation de dépôt;
- vu la grande rigidité de la cible, il est possible de placer la cathode suivant l'invention dans diverses positions, y compris une position inclinée, et même en porte à faux, sans affecter son bon fonctionnement ni les tolérances de fabrication.

D'autres particularités et avantages de la cathode suivant l'invention ressortiront de la description faite ci-après d'une forme de réalisation particulière, référence étant faite aux dessins annexés, dans lesquels :
la Fig. 1 est une vue en perspective, avec interruption et arrachement, d'une cathode rotative suivant l'invention;
la Fig. 2 est une coupe de la cathode de la Fig. 1 suivant un plan perpendiculaire à l'axe longitudinal de cette cathode;
la Fig. 3 est une vue schématique en coupe, suivant un plan perpendiculaire à l'axe d'une cathode à structure rotative double et à deux plans de pulvérisation parallèles;
la Fig. 4 est une vue schématique en coupe suivant un plan perpendiculaire à l'axe d'une cathode à double structure rotative et à un plan de pulvérisation;
la Fig. 5 est une coupe suivant un plan perpendiculaire à l'axe, d'une cathode analogue à celle de la Fig. 4, dotée de pièces polaires asymétriques, et
la Fig. 6 est une vue schématique en coupe suivant un plan perpendiculaire à l'axe, d'une cathode suivant l'invention, à double plan de projection.
La Fig. 7 est une vue en perspective avec arrachement d'une cathode avec gaine cryogénique.
La Fig. 8 est une vue en coupe suivant le plan VIII-VIII de la cathode de la Fig. 7.

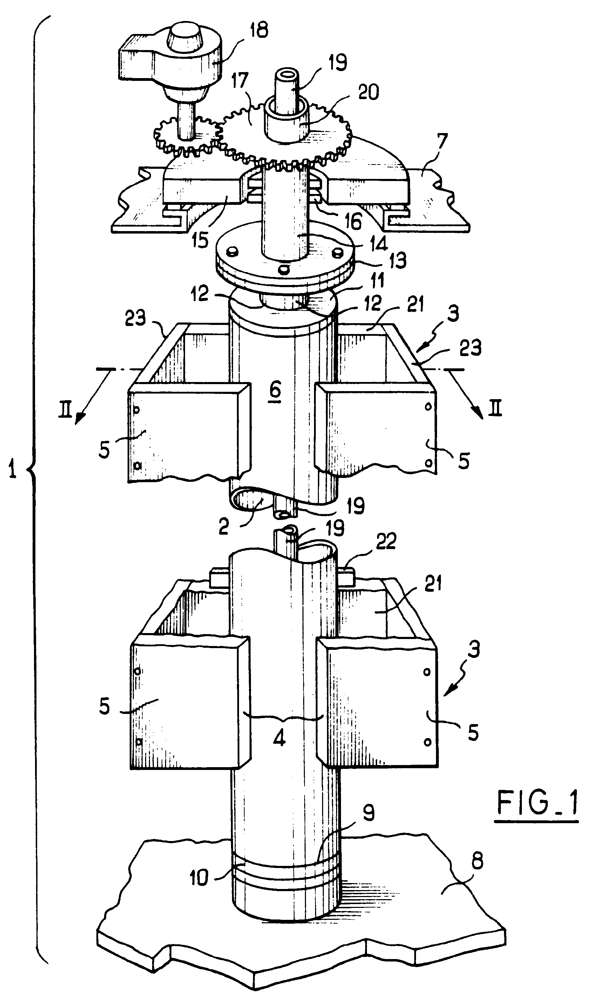

La Fig. 1 montre, en perspective, avec interruption, une cathode suivant l'invention avec son système d'entraînement et une vue arrachée de son enceinte.

La pièce centrale de la cathode 1 est une structure creuse et allongée 2, montrée ici avec son axe vertical. Cette structure creuse 2 affecte ici une forme cylindrique, mais elle pourrait également, sans sortir du cadre de l'invention, être renflée ou fusiforme.

La structure creuse 2 est pratiquement entourée par un circuit de confinement magnétique 3 qui s'étend donc entièrement à l'extérieur de cette structure 2.

La seule interruption de ce circuit magnétique est l'entrefer 4 qui s'étend entre les pièces polaires 5 disposées suivant l'axe de la structure creuse 2, de haut en bas de cette structure 2. La surface latérale de cette structure creuse 2 est constituée de métal à pulvériser. L'intervalle de surface latérale de la structure creuse disposée en regard de l'entrefer 4 séparant les pièces polaires 5 forme la "cible" 6 de la cathode 1.

La cathode 1 est représentée montée verticalement dans une chambre à vide, les parois supérieure 7 et inférieure 8 de cette chambre à vide étant figurées par une vue arrachée, l'entrefer 4 étant orienté parallèlement au plan de défilement des substrats (non représentés).

Le circuit magnétique de confinement 3 de la cathode 1 suivant l'invention est fixé dans la chambre à vide 7, 8 par des moyens de fixation connus, indépendamment de la structure creuse rotative 2.

Une des faces d'about 9 de la structure creuse 2 est fixée au plancher 8 par l'intermédiaire d'un plateau à galets 10, qui lui permet de tourner sur son axe et l'isole par rapport à l'enceinte 7, 8.

L'autre face d'about 11 comporte un col 12 auquel est fixée une bride 13. Par cette bride 13, la structure creuse rotative 2 est solidaire d'un arbre d'entraînement creux 14.

Cet arbre creux 14 s'étend au travers d'un passage rotatif 15 ménagé dans la paroi supérieure 7 de l'enceinte 7, 8. Des moyens d'isolation 16 isolent électriquement le corps du passage 15 et l'arbre 14.

Des moyens de transmission d'un couple rotatif 17 sont montés entre l'arbre d'entraînement 14 et un moteur d'entraînement 18 apte à entraîner la structure rotative creuse 2 en rotation. L'arbre d'entraînement 14 et l'axe de la structure rotative creuse 2 sont traversés en longueur par des conduits 19, 20 (disposés de façon coaxiale sur la Fig. 1) qui communiquent avec le volume interne de la structure creuse 2.

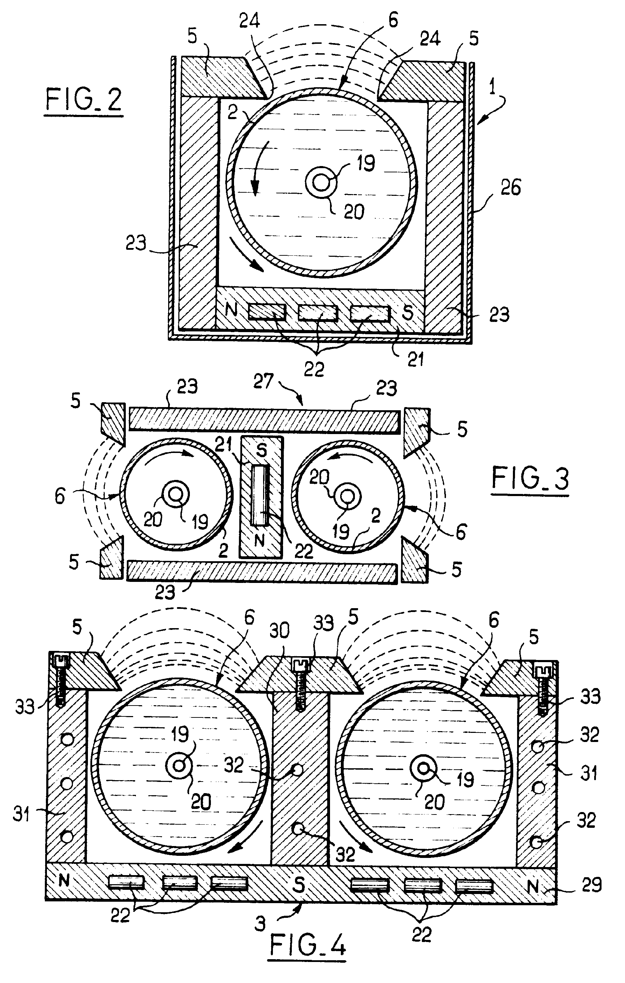

Comme on le verra à la Fig. 2, on peut ainsi faire passer dans cette structure 2, durant son fonctionnement, un débit important de fluide de refroidissement. Ce fluide est, de façon avantageuse, de l'eau. Le flux de liquide de refroidissement ne rencontre, à l'intérieur de la structure 2 même, pratiquement aucun obstacle, ce qui permet un refroidissement particulièrement énergique, quine peut être obtenu avec d'autres types de cathodes de puissance équivalente suivant l'art antérieur.

L'entrée et la sortie du liquide, de même que le système d'entraînement 17, 18 étant situés sur la même face d'about 11 de la structure creuse 2, l'entretien, la recharge ou le remplacement de la structure creuse 2 sont extrêmement aisés.

La structure creuse 2 de la cathode suivant l'invention peut en effet être extraite sans qu'il soit nécessaire de démontrer en même temps son circuit magnétique de confinement 3.

De surcroît, les dimensions et notamment le diamètre de la structure 2 ne sont pas limités vers le bas par la nécessité de laisser suffisamment de place pour des aimants et autres pièces magnétiques disposés à l'intérieur (comme dans l'art antérieur); la cathode 1 peut donc être réalisée en privilégiant une quelconque de ses caractéristiques dimensionnelles, en fonction du but recherché.

On peut ainsi donner à la structure creuse 2 de la cathode suivant l'invention, la forme de barres de relativement faible diamètre, aussi bien que celle de cylindres de grand diamètre pour le travail de métaux à bas point de fusion.

On peut également, en modifiant de façon concommitante la forme des pièces polaires, utiliser une structure creuse 2 en forme de volume de révolution dont la génératrice n'est pas une droite, mais une ligne courbe adaptée à la forme de substrats non plans.

La fabrication de telles structures rotatives creuses 2 peut s'effectuer en employant des techniques classiques ou des alternatives qui peuvent être, dans ce cas, économiquement intéressantes : moulage à la cire perdue, charge par pulvérisation plasma, sputtering et autres techniques connues de l'homme de métier.

Pour certaines applications, le plateau à galets 10 montré à la Fig. 1 peut également être monté du même côté que le passage rotatif 15, ce qui facilite le démontage et permet de travailler en porte à faux, par exemple pour pulvériser en largeur réduite, ce qui accroît la souplesse de production de certaines lignes de sputtering.

La Fig. 2 montre la cathode 1 en coupe suivant un plan perpendiculaire à son axe. La cavité intérieure de la structure creuse 2 est vue ici remplie entièrement d'un fluide de refroidissement (qui est, en l'occurrence, de l'eau) amené en permanence par le conduit central 19. Cette eau remonte dans la structure 2 en refroidissant les parois et le dos même de la zone "cible" 7 sans rencontrer d'obstacle, pour être évacuée coaxialement par le conduit 20.

Le circuit de confinement magnétique 3 est disposé entièrement à l'extérieur du volume de la structure creuse 2 et l'entoure presque complètement jusqu'aux pièces polaires 5.

Le circuit magnétique de confinement 3 est constitué d'un barreau central 21 sur lequel sont montés des aimants 22 permanents (ces aimants 22 permanents pourraient d'ailleurs être remplacés par des électroaimants).

Aux extrémités de ce barreau central 21 sont montées deux branches ou parties de circuit 23 portant les pièces polaires 5 orientées l'une vers l'autre et entre lesquelles s'étend l'entrefer.

Ces pièces polaires 5 ont la forme d'un coin. L'arête 24 de ce coin est dirigée vers la bordure de la cible 6. La face 25 des pièces polaires 5 dirigée vers l'entrefer 4 est, en substance, plane et s'étend dans un plan radial passant par le centre de la structure 2.

Cette configuration donne aux lignes de force magnétiques (représentées en pointillés), une courbure sensiblement parallèle à celle de la cible 6 et une répartition uniforme, propice à une répartition large de la zone d'érosion de la cible 6. Une électrode de blindage 26 est montée dans le voisinage immédiat de la cathode 1 et mise à la terre.

La Fig. 3 montre une autre cathode 27 suivant l'invention, à double plan de projection. La cathode 27 comporte deux structures creuses 2 cylindriques, disposées parallèlement à l'axe longitudinal de la cathode 27.

Les deux structures rotatives 2 sont séparées par un barreau magnétique 21 commun du circuit magnétique 3 de chacune d'elles, et dans lequel sont insérés des moyens magnétiques 22, en l'occurrence, des aimants permanents. Deux branches magnétiques 23 s'étendent à l'opposé l'une de l'autre à partir de chaque extrémité du barreau commun 21 sensiblement à la perpendiculaire de celui-ci; l'ensemble figurant un H, encadrant les deux structures creuses 2.

Des pièces polaires 5 sont montées à l'extrémité libre de chaque branche magnétique 23, pointant en direction de la structure creuse 2 qui lui est adjacente, de sorte que le flux magnétique engendré par les aimants 22 se referme de façon symétrique dans l'entrefer 4, à hauteur des deux cibles 6 de la cathode 27.

La cathode 27 a l'avantage de pouvoir pulvériser simultanément dans deux plans et de présenter un encombrement réduit par rapport à deux cathodes distinctes de performance équivalente.

La Fig. 4 montre une autre variante 28 de la cathode suivant l'invention, dans laquelle deux structures rotatives 2 sont montées côte à côte dans un circuit magnétique 3 commun et projettent dans un même plan.

Le circuit magnétique 3 affecte ici globalement la forme d'un E majuscule.

Des moyens magnétiques 22 sont disposés dans le barreau commun 29, qui figure la hampe du E, symétriquement par rapport à la branche centrale 30 qui se dresse entre les deux structures rotatives creuses 2 de la cathode 28. Les flux engendrés par les moyens magnétiques 22 passent respectivement par les branches extrêmes du circuit, dans les pièces polaires 5 fixées à ces branches 31, traversent l'entrefer au-dessus de chaque cible 6 et reviennent vers les moyens magnétiques 22 par la branche centrale commune 30, qui est de section plus forte pour éviter la saturation.

Les lignes de force du champ magnétique sont infléchies par la forme des pièces polaires 5 et suivent sensiblement la courbure des cibles 2.

Des canaux 32 traversent les pièces du circuit magnétique 3 de part en part. Ces canaux 32 sont, durant le fonctionnement de la cathode, parcourus par un fluide de refroidissement provenant d'un circuit distinct de celui de la structure creuse 2, de sorte que la température du circuit magnétique 3 peut être contrôlée de façon indépendante par rapport à celle des structures creuses 2 et des cibles 6.

Comme dans les exécutions montrées aux Fig. 1 et 2, les structures creuses 2 de la cathode 28 sont parcourues sur leur longueur par de l'eau amenée par un conduit coaxial central 19, 20.

Des dispositifs de fixation 33 solidarisent les pièces polaires 5 avec les branches magnétiques 30, 31. Le cas échéant, ces pièces polaires 5 peuvent être remplacées avec facilité (adoption d'un nouveau profil de cible, de substrat).

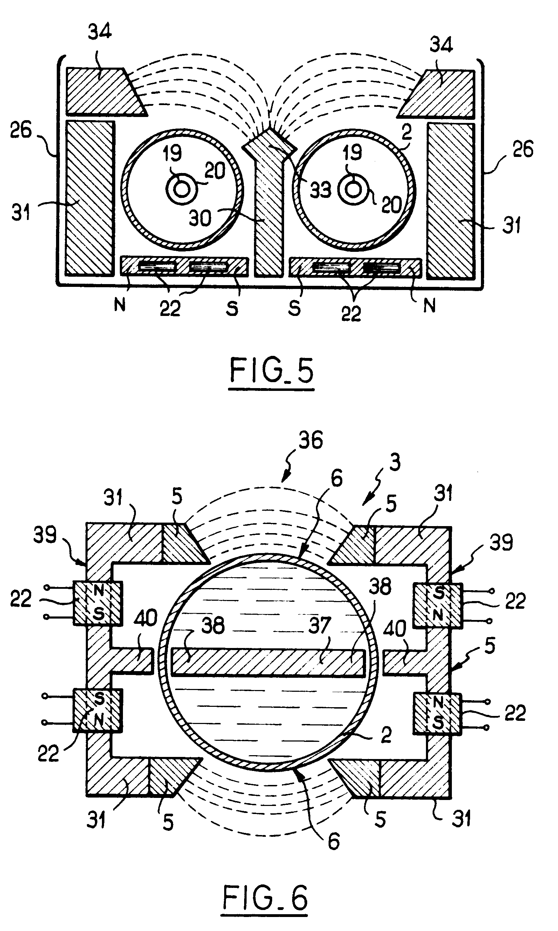

La Fig. 5 montre une variante de réalisation d'une cathode suivant l'invention du même type qu'à la Fig. 4, comportant cette fois des pièces polaires asymétriqes 34, 35.

Le circuit magnétique 3, vu de profil, présente l'allure générale d'un E majuscule, les pièces polaires 34, 35 étant disposées à l'extrémité de chaque branche, les branches 31, 32 encadrant les deux structures creuses 2. Les pièces polaires externes 34 et les branches 31 qui les supportent sont surdimensionnées par rapport à la branche centrale commune 32 et à sa pièce polaire 35. Cette conformation du circuit magnétique tend à déformer l'allure des lignes de force dans les deux entrefers 4. On peut ainsi laisser s'échapper de façon contrôlée une certaine quantité d'électrons confinés dans l'entrefer.

La Fig. 6 montre une forme avantageuse 36 d'une cathode rotative suivant l'invention, à une seule structure creuse 2 et double plan de pulvérisation. Cette cathode 36 comporte une structure creuse 2 cylindrique disposée centralement. Une pièce de pontage 37 en fer doux, de section rectangulaire, divise horizontalement, dans le plan diamétral, le volume interne 3 de la structure creuse 2.

Les extrémités 38 de cette pièce de pontage 37, maintenue immobile par rapport à la cathode 36 effleurent, sans la toucher, la face interne de la structure creuse 2. De part et d'autre de la structure 2 sont disposés symétriquement deux parties 39 des éléments composant le circuit magnétique 3 dans son ensemble. Ces parties 39 affectent respectivement la forme d'un E majuscule et d'un E majuscule inversé. La branche médiane qui forme une extension 40 de chaque partie 39 est alignée sur la structure creuse 2, juste en regard, mais du côté extérieur, d'une extrémité 38 de la pièce de pontage 37. Les branches externes 31 de chaque partie du circuit 39 (correspondant aux branches externes des E) portent des pièces polaires 5. Les pointes de ces pièces polaires délimitent de part et d'autre de la structure rotative creuse 2 deux arcs cylindriques, décalés angulairement de 180°, qui constituent les deux cibles 6 de la cathode 36.

Sur les deux parties en E, 39, du circuit magnétique, les hampes comportent des moyens magnétiques 22 (ici, des électroaimants) disposés en opposition, de façon à faire circuler deux flux magnétiques identiques en parallèle dans les entrefers. Ces flux disposent, pour se refermer, d'une partie commune, à savoir la pièce de pontage 37.

La présence de cette pièce profilée, de section réduite, n'altère nullement la dissipation de la chaleur dans la structure creuse 2 et le gain de place est considérable par rapport à l'emploi de deux cathodes distinctes de performances équivalentes.

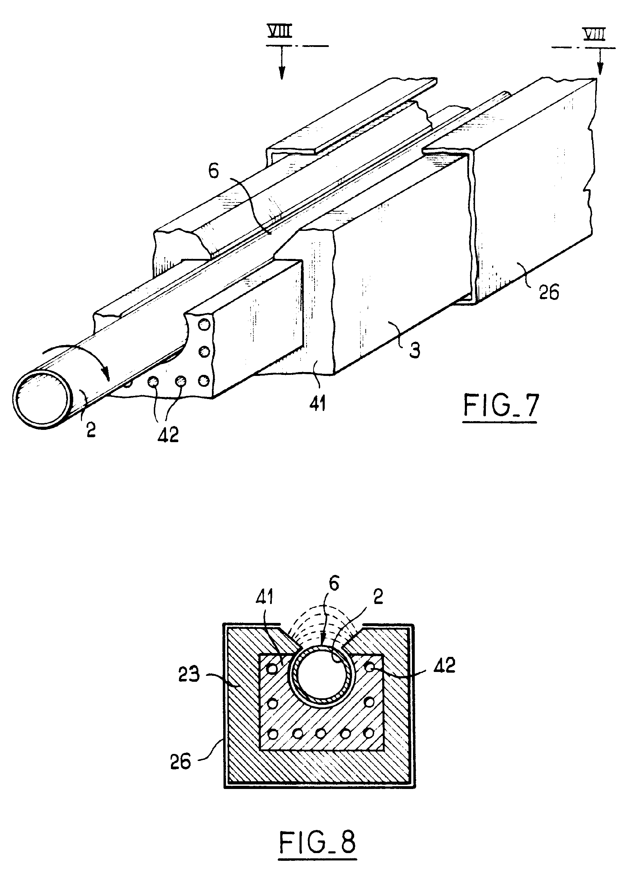

Les Figs. 7 et 8 montrent avec arrachement et en coupe, une autre cathode de pulvérisation suivant l'invention, dont la structure creuse 2 est entourée - à l'exception de l'arc cylindrique formant la cible 6 - d'une gaine 41 parcourue par des canaux 42 où circule un fluide cryogénique (tel que de l'hélium liquide, de l'azote ou du fréon). Cette gaine 41 est constituée d'un matériau non-magnétique et elle est conçue de façon à évacuer par effet radiatif un maximum de chaleur de la surface de la structure creuse 2. Cette gaine 41 peut, comme représenté aux Figs. 7 et 8, remplir presque complètement le volume compris entre le circuit magnétique externe 3 et la structure creuse rotative 2, ou être formé d'une plaque cintrée parcourue par des canaux 42 (ou à laquelle sont accolés des canaux) disposée à faible distance de la surface de la structure creuse 2, à l'exception de la cible.

L'abaissement de température à la surface de la structure creuse 2, joint au refroidissement énergique obtenu avec la cathode permet de pulvériser même des métaux à bas point de fusion sans problèmes.

## Revendications

1. Cathode de pulvérisation sous vide comportant une structure creuse (2) en substance en forme de corps de révolution pouvant tourner autour de son axe, comprenant une paroi latérale qui s'étend suivant l'axe et deux faces d'about en substance perpendiculaires à l'axe, ladite structure creuse (2) étant constituée, au moins à l'extérieur de sa paroi latérale, de matière à pulvériser, un circuit de confinement magnétique fixe disposé à proximité d'une cible (6), ce circuit comprenant des pôles, des pièces en métal magnétiquement perméable (21, 23, 29, 30, 31) et des moyens magnétiques (22) aptes à engendrer un flux magnétique dans ce circuit (3), des moyens de raccordement à un circuit de refroidissement apte à faire circuler un fluide de refroidissement dans la structure creuse (2), des moyens de raccordement à un circuit d'alimentation électrique, des moyens d'entraînements (17, 18) aptes à entraîner la structure creuses (2) en rotation autour de son axe, caractérisé en ce que :
le circuit magnétique (3) s'étend périphériquement par rapport à la structure creuse (2), les moyens magnétiques (22) étant disposés extérieurement à celle-ci, les pôles (5) du circuit magnétique étant disposés suivant deux lignes génératrices de cette structure creuse (2), l'arc de paroi latérale de la structure creuse (2) compris entre ces deux lignes génératrices formant la cible (6) de la cathode.

2. Cathode suivant la revendication 1, caractérisée en ce que la structure creuse (2), en substance en forme de corps de révolution, est un cylindre.

3. Cathode suivant l'une quelconque des revendications précédentes, caractérisée en ce que la paroi latérale extérieure de la structure creuse (2) est constituée par une couche massive de matière à pulvériser.

4. Cathode suivant l'une quelconque des revendications 1 à 3, caractérisée en ce que la structure creuse (2) comporte un support interne de forme appropriée recouvert de matière à pulvériser.

5. Cathode suivant l'une quelconque des revendications précédentes, caractérisée en ce que les moyens de raccordement à un circuit de refroidissement (19, 20) sont situés sur la même face d'about de la structure creuse (2).

6. Cathode suivant la revendication 5, caractérisée en ce que les moyens de raccordement (19, 20) au circuit de refroidissement sont coaxiaux.

7. Cathode suivant l'une quelconque des revendications précédentes, caractérisée en ce que les pièces du circuit magnétique comportent des moyens de raccordement à un circuit de refroidissement (32).

8. Cathode suivant l'une quelconque des revendications précédentes, caractérisée en ce que les pôles du circuit magnétique supportent une pièce polaire (5) dont la section a la forme d'un coin, l'arête de ladite pièce polaire (24) étant dirigée sensiblement vers le bord de la cible (6), la face (25) tournée vers l'entrefer (4), en substance plane, formant avec la surface de la cible (6), un angle proche de 90°, de façon telle que les lignes de force du champ magnétique s'étendent entre lesdites pièces polaires (5) suivant une courbure proche de celle de la cible (6) à proximité immédiate de celle-ci.

9. Cathode suivant l'une quelconque des revendications précédentes, caractérisée en ce qu'elle comporte deux structures creuses (2) disposées côte à côte, leur axe étant parallèle à l'axe de la cathode, leurs circuits magnétiques (3) respectifs comportant au moins une partie commune (30).

10. Cathode suivant la revendication 9, caractérisée en ce que les pièces polaires (5) des circuits magnétiques (3) de chaque structure creuse (2) sont toutes disposées d'un même côté de la cathode (28), de sorte que les cibles (6) correspondantes sont aptes à pulvériser, dans une même direction angulaire, une branche polaire (30) s'étendant entre les deux structures creuses (2) formant une partie commune aux deux circuits magnétiques (3), une pièce polaire commune (6, 35) étant portée par cette branche commune (30).

11. Cathode suivant la revendication 9, caractérisée en ce que les pièces polaires (6) des deux circuits magnétiques (3) sont disposées sur deux faces opposées de la cathode (27), les cibles (6) correspondant à chaque structure creuse (2) étant situées de façon diamétralement opposée l'une par rapport à l'autre, aptes à pulvériser dans deux plans parallèles, les circuits magnétiques (3) s'étendant périphériquement à chacune des structures creuses (2) et comportant une partie centrale commune (30) s'étendant entre lesdites structures (2).

12. Cathode de pulvérisation suivant la revendication 11, caractérisée en ce qu'elle comporte un nombre n de structures creuses (2) disposées parallèlement côte à côte, leurs circuits magnétiques respectifs (3) comportant au moins une partie commune.

13. Cathode suivant l'une quelconque des revendications précédentes caractérisée en ce que la structure creuse rotative est entourée, à l'exclusion de l'arc formant la cible, d'une gaine parcourue par un fluide cryogénique, apte à provoquer un échange thermique radiatif avec la surface latérale de la cible.

14. Cathode de pulvérisation sous vide comportant une structure creuse (2) en substance en forme de corps de révolution pouvant tourner autour de son axe comprenant une paroi latérale qui s'étend suivant cet axe et deux faces d'about en substance perpendiculaires à cet axe, ladite structure creuse (2) étant constituée au moins à l'extérieur de sa paroi latérale de matière à pulvériser, un circuit de confinement magnétique fixe disposé à proximité d'une cible, ce circuit comportant des pôles, des pièces en métal magnétiquement perméable (21, 23, 29, 30, 31) et des moyens magnétiques (22) aptes à engendrer un flux magnétique dans ce circuit (3), des moyens de raccordement à un circuit de refroidissement apte à faire circuler un fluide de refroidissement dans la structure creuse (2), des moyens d'entraînement (17, 18) aptes à entraîner la structure creuse (2) en rotation autour de son axe, caractérisé en ce que
- le circuit magnétique (3, 39) forme deux boucles se refermant de façon symétrique, les moyens magnétiques, les pôles et la majeure partie du circuit magnétique étant disposés extérieurement à la structure creuse (2) de part et d'autre de celle-ci, les pôles magnétiques de chaque boucle étant disposés suivant deux lignes génératrices de cette structure (2), déterminant des serpents angulaires diamétralement opposés sur la paroi latérale de cette structure (2), ces segments angulaires constituant deux cibles (6) aptes à pulvériser de la matière dans deux directions opposées
- les parties (39) du circuit magnétique (3, 39) disposées de part et d'autre à l'extérieur de la structure creuse (2) sont reliées magnétiquement par un noyau de pontage (37) en fer doux placé de façon non rotative à l'intérieur de cette structure creuse (2) suivant le plan transversal comprenant l'axe de la cathode, chaque extrémité (38) de ce noyau de pontage (37) venant en regard, par-delà la paroi latérale de la structure creuse (2), d'une extension (40) des parties du circuit magnétique (39) disposées à l'extérieur de la structure creuse (2).

## Patentansprüche

1. Kathode zur Vakuumzerstäuberung umfassend einen Hohlkörper (2) im wesentlichen in Form eines Rotationskörpers, welcher um seine Achse rotieren kann, mit einer Seitenwand, die sich entlang der Achse erstreckt, und zwei Stirnseiten im wesentlichen senkrecht zur Achse, wobei der Hohlkörper (2) mindestens am Äußeren seiner Seitenwand aus zu verstäubendem Material gebildet ist, mit einem Magnetkreis zum magnetischen Einschluß, der nahe einem Target (6) vorgesehen ist, und Pole, Teile aus magnetisch-permeablem Metall (21, 23, 29, 30, 31) und Magnetisiermittel (22), die zur Erzeugung eines magnetischen Flusses in dem Magnetkreis (3) geeignet sind, und mit einer Einrichtung zur Verbindung mit einem Kühlkreis für die Zirkulierung einer Kühlflüssigkeit in dem Hohlkörper (2), mit einer Einrichtung zur Verbindung mit einem elektrischen Versorgungskreis, und mit einer Triebeinrichtung (17, 18) zur Drehung des Hohlkörpers (2) um seine Achse, **dadurch gekennzeichnet,** daß
der Magnetkreis (3) sich peripher in Bezug auf den Hohlkörper (2) erstreckt, das Magnetisiermittel (22) außerhalb diesem vorgesehen ist, die Pole (5) des Magnetkreises entlang zweier Erzeugenden dieses Hohlkörpers (2) vorgesehen sind und einen Bogen der Seitenwand des Hohlkörpers (2), der sich zwischen diesen beiden Erzeugenden befindet, das Target (6) der Kathode bildet.

2. Kathode nach Anspruch 1, **dadurch gekennzeichnet,** daß der Hohlkörper (2), der im wesentlichen aus einem Rotationskörper gebildet ist, ein Zylinder ist.

3. Kathode nach einem der vorhergehenden Ansprüche, **dadurch gekennzeichnet,** daß die äußere Seitenwand des Hohlkörpers (2) aus einer massiven Schicht aus Pulverisiermaterial gebildet ist.

4. Kathode nach einem der vorhergehenden Ansprüche 1 bis 3, **dadurch gekennzeichnet,** daß der Hohlkörper (2) eine innere Stütze in geeigneter Form umfaßt, die von Pulverisiermaterial bedeckt ist.

5. Kathode nach einem der vorhergehenden Ansprüche, **dadurch gekennzeichnet,** daß die Einrichtungen zur Verbindung mit dem Kühlkreis (19, 20) an der gleichen Stirnseite des Hohlkörpers (2) vorgesehen sind.

6. Kathode nach Anspruch 5, **dadurch gekennzeichnet,** daß die Einrichtungen zur Verbindung mit dem Kühlkreis (19, 20) koaxial sind.

7. Kathode nach einem der vorhergehenden Ansprüche, **dadurch gekennzeichnet,** daß die Teile des Magnetkreises eine Verbindungseinrichtung zu einem Kühlkreis (32) umfassen.

8. Kathode nach einem der vorhergehenden Ansprüche, **dadurch gekennzeichnet,** daß die Pole des Magnetkreises ein Polteil (5) umfassen, dessen Querschnitt die Form einer Ecke aufweist, wobei die Kante des Polteils (24) im wesentlichen in Richtung des Randes des Target (6) gerichtet ist, und die Seite (25), die gegen den Spalt (4) gekehrt ist, im wesentlichen eben ist, wobei sie mit der Oberfläche des Targets (6) einen Winkel nahe 90 Grad bildet, in der Weise, daß die Magnetfeldlinien zwischen den Polstücken (5) sich in einer Kurve nahe der des Targets (6) in unmittelbarer Nähe zu dieser erstrecken.

9. Kathode nach einem der vorhergehenden Ansprüche, **dadurch gekennzeichnet,** daß sie zwei Hohlkörper (2) umfaßt, die nebeneinander angeordnet sind, wobei ihre Achsen parallel zur Achse der Kathode sind, und wobei die jeweiligen Magnetkreise (3) mindestens einen gemeinsamen Teil (30) umfassen.

10. Kathode nach Anspruch 9, **dadurch gekennzeichnet,** daß die Polstücke (5) der Magnetkreise (3) jedes Hohlkörpers (2) auf einer gleichen Seite der Kathode (8) in der Weise vorgesehen sind, daß die entsprechenden Targets (6) geeignet sind, in die selbe Winkelrichtung zu pulverisieren, wobei ein Polzweig (30) sich zwischen den beiden Hohlkörpern (2) erstreckt und einen gemeinsamen Teil der beiden Magnetkreise (3) bildet, und wobei das gemeinsame Polteil (6, 35) durch diesen gemeinsamen Zweig (30) getragen wird.

11. Kathode nach Anspruch 9, **dadurch gekennzeichnet,** daß die Polteile (6) der beiden Magnetkreise (3) an zwei gegenüberliegenden Seiten der Kathode (27) vorgesehen sind, wobei die Targets (6) jedes Hohlkörpers (2) diametral entgegengesetzt zueinander vorgesehen sind und in zwei parallelen Ebenen pulverisieren, wobei sich die Magnetkreise (3) peripher zu jedem Hohlkörper (2) erstrecken und einen zentralen gemeinsamen Teil (30) umfassen, welcher sich zwischen den beiden Körpern (2) erstreckt.

12. Kathode zur Pulverisierung nach Anspruch 11, **dadurch gekennzeichnet,** daß sie eine Anzahl n von Hohlkörpern (2) umfaßt, die parallel Seite an Seite angeordnet sind, wobei die jeweiligen magnetischen Schaltkreise (3) mindestens einen gemeinsamen Teil umfassen.

13. Kathode nach einem der vorhergehenden Ansprüche, **dadurch gekennzeichnet,** daß der rotierende Hohlkörper unter Ausschluß des Bogens, welcher das Target bildet, von einem Mantel umgeben ist, der von einer cryogenen Flüssigkeit durchströmt wird und geeignet ist, einen Strahlungswärmeaustausch mit der Seitenfläche des Targets herzustellen.

14. Kathode zur Vakuumzerstäuberung umfassend einen Hohlkörper (2) nur im wesentlichen der Form eines Rotationskörpers, welcher um seine Achse rotieren kann, mit einer Seitenwand, die sich entlang der Achse erstreckt, zwei Stirnseiten im wesentlichen senkrecht zur Achse, wobei der Hohlkörper (2) mindestens am Äußeren seiner Seitenwand aus zu pulverisierendem Material besteht, mit einem Magnetkreis zum magnetischen Einschluß, der nahe einem Target (6) vorgesehen ist und Pole, Teile aus magnetisch-permeablem Metall (21, 23, 29, 30, 31) und Magnetisiermittel (22) umfaßt, die zur Erzeugung eines magnetischen Flusses in dem Magnetkreis (3) vorgesehen sind, mit einer Einrichtung zur Verbindung mit einem Kühlkreis für die Zirkulierung einer Kühlflüssigkeit in dem Hohlkörper (2), mit einer Einrichtung zur Verbindung mit einem elektrischen Versorgungskreis, und mit einer Triebeinrichtung (17, 18), zur Rotation des Hohlkörpers (2), **dadurch gekennzeichnet,** daß
- der Magnetkreis (3, 39) zwei Schleifen bildet, die sich in symmetrischer Weise schließen, wobei die Magnetisiermittel, die Pole und der größte Teil des Magnetkreises außerhalb des Hohlkörpers (2) beiderseits diesem vorgesehen sind, und wobei die Magnetpole jeder Schleife entlang zweier Erzeugenden dieses Körpers (2) angeordnet sind, wodurch Winkelsegmente bestimmt werden, die diametral entgegengesetzt zur Seitenwand dieses Körpers (2) sind, wobei diese Winkelsegmente zwei Targets (6) für die Verstäubung des Materials in zwei entgegengesetzten Richtungen bilden,
- die Teile (39) des Magnetkreises (3, 39), welche beiderseits am Äußeren des Hohlkörpers (2) vorgesehen sind, magnetisch mittels eines Brückenkerns aus Weicheisen verbunden sind, welcher in nicht rotierender Weise im Innern des Hohlkörpers (2) in einer die Kathodenachse enthaltenden Querebene angeordnet ist, wobei jedes Ende (38) des Brückenkerns (37) bezüglich der Seitenwand des Hohlkörpers (2) einem Vorsprung (40) von Teilen der Magnetkreise (39) gegenüberliegt, die außerhalb des Hohlkörpers (2) angeordnet sind.

## Claims

1. Vacuum sputtering cathode having a hollow structure (2) substantially in the form of solids of revolution able to rotate about its aris, having a side wall extending along the axis and two end faces substantially perpendicular to the axis, said hollow structure (2) being constituted, at least externally of its side wall, by material to be sputtered, a fixed magnetic confinement circuit located in the vicinity of a target (6) said circuit comprising poles, magnetically permeable metal parts (21,23,29,30,31) and magnetic means (22) able to produce a magnetic flux in said circuit (3), means for connection to a cooling circuit able to make a cooling fluid flow in the hollow structure (2), means for connection to an electric power supply circuit and driving means (17,18) able to rotate the hollow structure (2) about its axis, characterized in that the magnetic circuit (3) extends peripherally with respect to the hollow structure (2), the magnetic means (22) being arranged externally thereof, the poles (5) of the magnetic circuit being positioned in accordance with two generating lines of said hollow structure (2), the side wall arc of the hollow structure (2) between these two generating lines forming the cathode target (6).

2. Cathode according to claim 1, characterized in that the hollow structure (2), substantially in the form of solids of revolution is a cylinder.

3. Cathode according to any one of the preceding claims, characterized in that the outer side wall of the hollow structure (2) is constituted by a solid layer of material to be sputtered.

4. Cathode according to any one of the claims 1 to 3, characterized in that the hollow structure (2) has an appropriately shaped internal support covered with material to be sputtered.

5. Cathode according to any one of the preceding claims, characterized in that the connecting means to a cooling circuit (19,20) are located on the same end face of the hollow structure (2).

6. Cathode according to claim 5, characterized in that the connecting means (19,20) to the cooling circuit are coaxial.

7. Cathode according to any one of the preceding claims, characterized in that the parts of the magnetic circuit have connection means to a cooling circuit (32).

8. Cathode according to any one of the preceding claims, characterized in that the poles of the magnetic circuit support a pole piece (5), whose section is wedge-shaped, the edge of said pole piece (24) being directed substantially towards the edge of the target (6), the face (25) turned towards the substantially planar air gap (4) forming with the surface of the target (6) an angle close to 90°, in such a way that the lines of force of the magnetic field extend between said pole pieces (5) in accordance with a curvature close to that of the target (6) in the immediate vicinity thereof.

9. Cathode according to any one of the preceding claims, characterized in that it has two juxtaposed hollow structures (2), their axis being parallel to the cathode axis and their respective magnetic circuits (3) having at least one common part (30).

10. Cathode according to claim 9,characterized in that the pole pieces (5) of the magnetic circuits (3) of each hollow structure (2) are all located on the same side of the cathode (28), so that the corresponding targets (6) are able to sputter, in the same angular direction, a pole branch (30) extending between the two hollow structures (2) forming a common part with the two magnetic circuits (3), a common pole piece (6,35) being carried by said common branch (30).

11. Cathode according to claim 9, characterized in that the pole pieces (6) of the two magnetic circuits (3) are placed on the two opposite faces of the cathode (27), the targets (6) corresponding to each hollow structure (2) being positioned diametrically opposite one another and being able to sputter in two parallel planes, the magnetic circuits (3) extending peripherally of each of the hollow structures (2) and having a common central part (30) extending between said structures (2).

12. Sputtering cathode according to claim 11, characterized in that it has a number n of hollow structures (2) arranged in parallel, juxtaposed manner, their respective magnetic circuits (3) having at least one common part.

13. Cathode according to any one of the preceding claims, characterized in that the rotary hollow structure is surrounded, with the exception of the arc forming the target, by a sheath traversed by a cryogenic fluid, able to bring about radiative thermal exchange with the lateral surface of the target.

14. Vacuum sputtering cathode having a hollow structure (2) substantially formed by solids of revolution able to rotate about its axis and having a side wall, which extends along said axis and two end faces substantially perpendicular to said axis, said hollow structure (2) being constituted, at least outside its side wall, from the material to be sputtered, a fixed, magnetic confinement circuit located in the vicinity of a target, said circuit having poles, magnetically permeable metal parts (21,23,29,30,31) and magnetic means (22) able to produce a magnetic flux in said circuit (3), connecting means to a cooling circuit able to bring about a circulation of a cooling fluid in the hollow structure (2), driving means (17,18) able to drive the hollow structure (2) in rotary manner about its axis, characterized in that the magnetic circuit (3,39) forms two loops closing in a symmetrical manner, the magnetic means, the poles and most of the magnetic circuit being positioned externally of the hollow structure (2) on either side of the latter, the magnetic poles of each loop being arranged along two generating lines of said structure (2), defining diametrically opposite angular segments on the side wall of said structure (2), said angular segments constituting two targets (6) able to sputter the material in two opposite directions and the parts (39) of the magnetic circuit (3,39) located on either side on the exterior of the hollow structure (2) are magnetically connected by a bridging core (37) made from soft iron positioned in non-rotary manner within said hollow structure (2) in accordance with the transverse plane incorporating the asis of the cathode, each end (38) of said bridging core (37) being positioned, beyond the side wall of the hollow structure (2), facing an extension (40) of the parts of the magnetic circuit (39) positioned outside the hollow structure (2).
